# EUROPEAN PATENT SPECIFICATION

(11) **EP 4 380 324 B1**
(45) Date of publication and mention of the grant of the patent: **01.04.2026**
(21) Application number: 22881241.8
(22) Date of filing: 22.09.2022
(51) Int. Cl.: H05K 3/32, H05K 3/40, H01R 43/02

(54) **PRINTED CIRCUIT BOARD, MANUFACTURING METHOD THEREFOR, AND BATTERY PACK COMPRISING SAME**
LEITERPLATTE, HERSTELLUNGSVERFAHREN DAFÜR UND BATTERIEPACK DAMIT
CARTE DE CIRCUIT IMPRIMÉ, SON PROCÉDÉ DE FABRICATION ET BLOC-BATTERIE LA COMPRENANT

(30) Priority: 12.10.2021 KR 20210134806
(43) Date of publication of application: 05.06.2024
(73) Proprietor: LG Energy Solution, Ltd., Seoul 07335 (KR)
(72) Inventor: JANG, Jae Young, Daejeon 34122 (KR); LEE, Jin Hyun, Daejeon 34122 (KR); SON, Min Su, Daejeon 34122 (KR)
(74) Representative: Plasseraud IP
(86) International application number: PCT/KR2022/014178
(87) International publication number: WO 2023/063612

(56) References cited:
- EP-A1- 2 755 456
- WO-A1-99/49708
- DE-A1- 102018 219 037
- DE-A1- 19 522 338
- JP-A- 2014 135 166
- KR-A- 20150 122 409
- KR-A- 20190 046 511
- KR-B1- 101 103 301
- US-A1- 2009 084 589
- US-B2- 6 655 967

## Description

### [TECHNICAL FIELD]

### Cross Citation with Related Application(s)

This application claims the benefit of Korean Patent Application No. 10-2021-0134806 filed on October 12, 2021 with the Korean Intellectual Property Office.

The present disclosure relates to a printed circuit board and a battery pack including the same, and more particularly, to a printed circuit board having excellent durability and a battery pack including the same.

### [BACKGROUND]

In modern society, as portable devices such as a mobile phone, a notebook computer, a camcorder and a digital camera has been daily used, the development of technologies in the fields related to mobile devices as described above has been activated. In addition, a chargeable/dischargeable secondary battery is used as a power source for an electric vehicle (EV), a hybrid electric vehicle (HEV), a plug-in hybrid electric vehicle (P-HEV) and the like, as a part of a method of solving air pollution and the like caused by existing gasoline vehicles using fossil fuel. Therefore, the need for developing the secondary battery has been increasing.

Currently commercialized secondary batteries include a nickel cadmium battery, a nickel hydrogen battery, a nickel zinc battery, and a lithium secondary battery. Among them, the lithium secondary battery has come into the spotlight because they have advantages, for example, hardly exhibiting memory effects compared to nickel-based secondary batteries and thus being freely charged and discharged, and having very low self-discharge rate and high energy density.

Such lithium secondary battery mainly uses a lithium-based oxide and a carbonaceous material as a cathode active material and an anode active material, respectively. The lithium secondary battery includes an electrode assembly in which a cathode plate and an anode plate, each being coated with the cathode active material and the anode active material, are arranged with a separator being interposed between them, and a battery case which seals and houses the electrode assembly together with an electrolytic solution.

Generally, the lithium secondary battery may be classified based on the shape of the exterior material into a can-type secondary battery in which the electrode assembly is built into a metal can, and a pouch-type secondary battery in which the electrode assembly is built into a pouch of an aluminum laminate sheet.

In the case of a secondary battery used for small-sized devices, two to three battery cells are arranged, but in the case of a secondary battery used for a middle or large-sized device such as an automobile, a battery module in which a large number of battery cells are electrically connected is used. In such a battery module, a large number of battery cells are connected to each other in series or parallel to form a cell assembly, thereby improving capacity and output. One or more battery modules can be mounted together with various control and protection systems such as a BMS (Battery Management System) and a cooling system to form a battery pack.

At this time, in the case of a printed circuit board (PCB) that is used as a constituent element of a battery pack's BMS (Battery Management System) and the like, it generally includes an inner layer, and an insulating layer and a copper foil layer stacked on the upper and lower parts on the basis of the inner layer. DE 10 2018 219037 A1 discloses a method for welding a flexible printed circuit board to a contact pad of a battery.

Wherein, when performing welding for connecting the metal tab on the printed circuit board, there was a risk that the inner layers of the printed circuit board will be damaged by welding.

In particular, when the inner layer of the printed circuit board is damaged, damage to the inner layer pattern occurs, whereby not only it is difficult to perform the functions of the printed circuit board, but also there is a high possibility that the insulating layer will be destroyed and disconnection will occur.

Therefore, when welding the metal tab onto the printed circuit board, there is a need for a structure that can prevent damage to the inner layer of the printed circuit board.

### [DETAILED DESCRIPTION OF THE INVENTION]

### [Technical Problem]

It is an object of the present disclosure to provide a printed circuit board that can prevent damage to the inner layer that occurs during welding, and a battery pack including the same.

However, the objects of the present disclosure are not limited to the aforementioned objects, and other objects which are not mentioned herein should be clearly understood by those skilled in the art from the following detailed description and the accompanying drawings.

### [Technical Solution]

According to an aspect of the present disclosure, there is provided a printed circuit board comprising: an inner layer; a first insulating layer formed on an upper part of the inner layer; a first copper foil layer formed on an upper part of the first insulating layer; and a solder resist layer formed on an upper part of the first copper foil layer, wherein when welding a metal tab onto the solder resist layer, a welded portion that couples the metal tab and the first copper foil layer is formed, and a gap is formed at a portion adjacent to the welded portion.

The gap separates the metal tab and the first copper foil layer.

When welding the metal tab, a part or all of the solder resist layer may be removed to form the gap.

The gap may be between 50 µm and 200 µm.

The solder resist layer may cover a part of the first copper foil layer.

The solder resist layer may cover an outer edge part of the first copper foil layer.

An outer size of the solder resist layer may be formed to be larger than an outer size of the first copper foil layer.

A size of the solder resist layer may be formed to be smaller than or equal to a size of the metal tab.

A size of the first copper foil layer may be formed to be smaller than a size of the metal tab.

The metal tab may be connected to the first copper foil layer via the welding.

According to another aspect of the present disclosure, there is provided a manufacturing method of a printed circuit board, the method comprising the steps of: forming an inner layer, a first insulating layer formed on an upper part of the inner layer, and a first copper foil layer formed on an upper part of the first insulating layer; and forming a solder resist layer on an upper part of the first copper foil layer, wherein when welding a metal tab onto the solder resist layer, a welded portion that couples the metal tab and the first copper foil layer is formed, and a gap is formed at a portion adjacent to the welded portion.

According to yet another aspect of the present disclosure, there is provided a battery pack comprising the above-mentioned printed circuit board.

### [Advantageous Effects]

A printed circuit board according to the present disclosure includes a solder resist layer present on the copper foil layer, and thus can prevent damage to the inner layer of the printed circuit board when welding the metal tab.

The effects of the present disclosure are not limited to the effects mentioned above and additional other effects not described above will be clearly understood from the description of the appended claims by those skilled in the art.

### [BRIEF DESCRIPTION OF THE DRAWINGS]

Fig. 1 is a cross-sectional view showing the structure of a printed circuit board according to an embodiment of the present disclosure;
Fig. 2 is a plan view of the printed circuit board of Fig. 1 as viewed from above;
Fig. 3 is a cross-sectional view showing the structure before a metal tab is welded onto the printed circuit board of Fig. 1;
Fig. 4 is a cross-sectional view showing the structure of a printed circuit board according to another embodiment of the present disclosure;
Fig. 5 is a cross-sectional view showing the structure of a printed circuit board in which the printed circuit board of Fig. 4 is partially deformed;
Fig. 6 is a plan view of the printed circuit board of Fig. 5 as viewed from above;
Fig. 7 is a cross-sectional view showing the structure before a metal tab is welded onto the printed circuit board of Fig. 5; and
Fig. 8 is a cross-sectional view showing the structure of a printed circuit board in the process of welding a metal tab.

### [DETAILED DESCRIPTION OF THE EMBODIMENTS]

Hereinafter, various embodiments of the present disclosure will be described in detail with reference to the accompanying drawings so that those skilled in the art can easily carry out them. The present disclosure may be modified in various different ways, and is not limited to the embodiments set forth herein.

Portions that are irrelevant to the description will be omitted to clearly describe the present disclosure, and like reference numerals designate like elements throughout the description.

Further, in the drawings, the size and thickness of each element are arbitrarily illustrated for convenience of description, and the present disclosure is not necessarily limited to those illustrated in the drawings. In the drawings, the thickness of layers, regions, etc. are exaggerated for clarity. In the drawings, for convenience of description, the thicknesses of some layers and regions are exaggerated.

In addition, it will be understood that when an element such as a layer, film, region, or plate is referred to as being "on" or "above" another element, it can be directly on the other element or intervening elements may also be present. In contrast, when an element is referred to as being "directly on" another element, it means that other intervening elements are not present. Further, the word "on" or "above" means disposed on or below a reference portion, and does not necessarily mean being disposed on the upper end of the reference portion toward the opposite direction of gravity.

Further, throughout the description, when a portion is referred to as "including" or "comprising" a certain component, it means that the portion can further include other components, without excluding the other components, unless otherwise stated.

Further, throughout the description, when referred to as "planar", it means when a target portion is viewed from the upper side, and when referred to as "cross-sectional", it means when a target portion is viewed from the side of a cross section cut vertically.

The terms "first," "second," etc. are used herein to explain various components, but the components should not be limited by the terms. These terms are only used to distinguish one component from the other component.

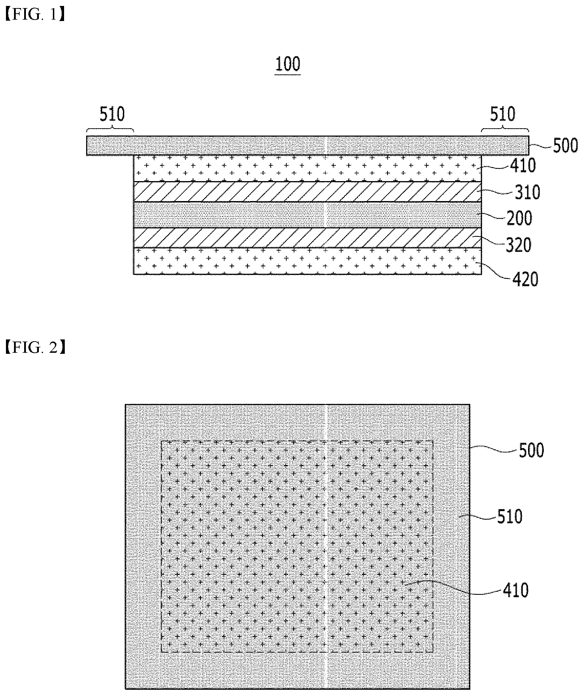

Now, a printed circuit board according to one embodiment of the present disclosure will be described with reference to Figs. 1 to 3, and Fig. 8.

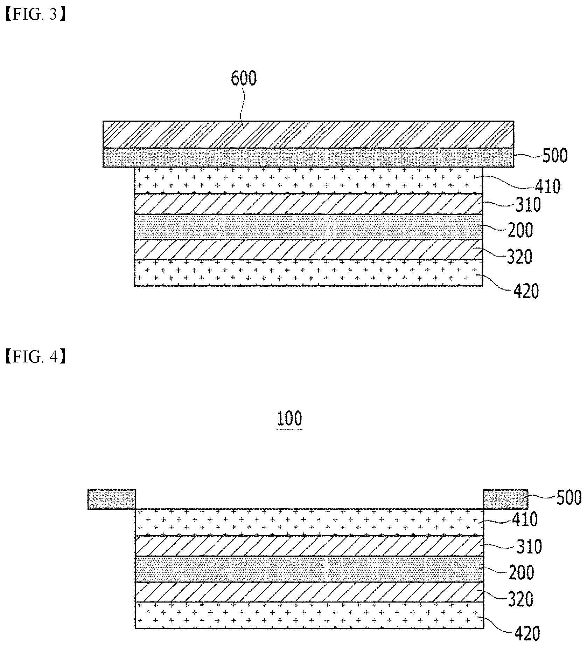

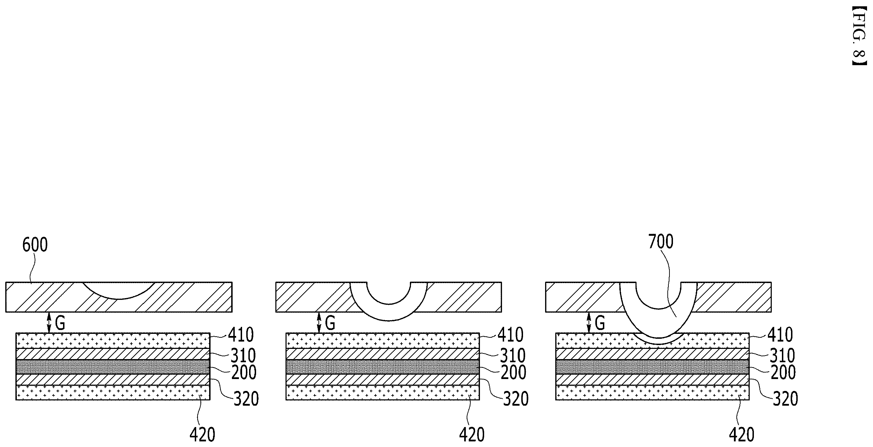

Fig. 1 is a cross-sectional view showing the structure of a printed circuit board according to an embodiment of the present disclosure. Fig. 2 is a plan view of the printed circuit board of Fig. 1 as viewed from above. Fig. 3 is a cross-sectional view showing the structure before a metal tab is welded onto the printed circuit board of Fig. 1. Fig. 8 is a cross-sectional view showing the structure of a printed circuit board in the process of welding a metal tab.

Referring to Fig. 1, a printed circuit board (PCB) 100 according to the present embodiment includes an inner layer 200; a first insulating layer 310 formed on an upper part of the inner layer 200; and a second insulating layer 320 formed on a lower part of the inner layer 200. Also, the printed circuit board 100 includes a first copper foil layer 410 formed on an upper part of the first insulating layer 310, a second copper foil layer 420 formed on a lower part of the second insulating layer 320, and a solder resist layer 500 formed on an upper part of the first copper foil layer 410.

At this time, the inner layer 200 may be a paper core layer impregnated with epoxy resin or a glass fiber layer impregnated with epoxy resin, and more specifically, it may be FR-4. Also, the first insulating layer 310 and the second insulating layer 320 may be formed of the same material, and the material may be prepreg (PPG, Pre Preg). The solder resist layer 500 according to the present embodiment may be specifically a photo solder resist (PSR) layer.

Conventionally, there was a risk of damaging the inner layer of a printed circuit board when welding with a metal tab. When the inner layer is damaged, not only the pattern of the inner layer is damaged but also the insulating layer is destroyed, which caused a problem that the occurrence of disconnection increases.

Therefore, referring to Fig. 8, the printed circuit board 100 according to the present embodiment is configured such that when welding the metal tab 600 onto the solder resist layer 500, a welding portion 700 that couples the metal tab 600 and the first copper foil layer 410 is formed, and a gap G is formed at a portion adjacent to the welding portion 700. At this time, the metal tab 600 may be a copper tab or a nickel tab, and specifically may be a nickel tab, but is not limited thereto.

Looking more closely at Fig. 8, although the solder resist layer 500 is not shown in Fig. 8, a gap G formed between the metal tab 600 and the first copper foil layer 410 may match or correspond to the thickness of the solder resist layer 500.

The gap G may separate the metal tab 600 and the first copper foil layer 410, and particularly, the gap G can be formed on both sides on the basis of the welding portion 700 to secure a separation distance between the metal tab 600 and the first copper foil layer 410.

When the metal tab 600 is welded onto the printed circuit board 100 in order to form the gap G, a part or all of the solder resist layer 500 may be removed. This is for removing the solder resist layer 500 by the heat generated by welding, and even if a part or all of the solder resist layer 500 is removed, a part of the metal tab 600 is connected to the first copper foil layer 410 by the welding, so that a metal tab 600 can be welded onto the printed circuit board 100. At this time, the gap G increases the distance between the metal tab 600 and the inner layer 200, which prevents a part of the molten metal tab 600 from reaching the inner layer 200 even if the metal tab 600 is welded, thereby capable of preventing damage to the inner layer 200. Therefore, when welding the metal tab 600, a part or all of the solder resist layer 500 can be removed to form a gap G between the metal tab 600 and the first copper foil layer 410. At this time, even if the gap G is formed, the metal tab 600 may be connected to the first copper foil layer 410 via the welding, and particularly, the metal tab 600 and the first copper foil layer 410 may be connected via the welding portion 700.

The thickness of the solder resist layer 500 according to the present embodiment may be between 50 µm and 200 µm, preferably between 75 µm and 150 µm, and more preferably between 80 µm and 100 µm.

Therefore, the gap G may also be formed in a range of 50 µm to 200 µm, preferably in a range of 75 µm to 150 µm, and more preferably in a range of 80 µm to 100 µm.

Meanwhile, the solder resist layer 500 may cover the entire surface of the first copper foil layer 410. Referring to Fig. 2, the front surface of the first copper foil layer 410 may mean the whole surface of the first copper foil layer 410 as viewed from above. Therefore, as shown in Fig. 2, the solder resist layer 500 may cover the entire surface of the first copper foil layer 410. At this time, the size of the solder resist layer 500 may be equal to or greater than the size of the first copper foil layer 410. Therefore, when the size of the solder resist layer 500 is larger than the size of the first copper foil layer 410, an outer surface 510 of the solder resist layer may be formed. The outer surface 510 of the solder resist layer may allow the metal tab 600 to be stably formed and welded onto the printed circuit board 100 and the solder resist layer 500 .

Referring to Fig. 3, the size of the solder resist layer 500 may be formed to be smaller than or equal to the size of the metal tab 600. The size of the first copper foil layer 410 may be formed to be smaller than that of the metal tab 600. By forming to the above size, it is possible to ensure welding stability between the metal tab 600 and the printed circuit board 100.

Next, a printed circuit board according to another embodiment of the present disclosure will be described with reference to Figs. 4 to 8. Since there are redundant contents that overlap with those described above, only the portions that differ from the contents described above will be described.

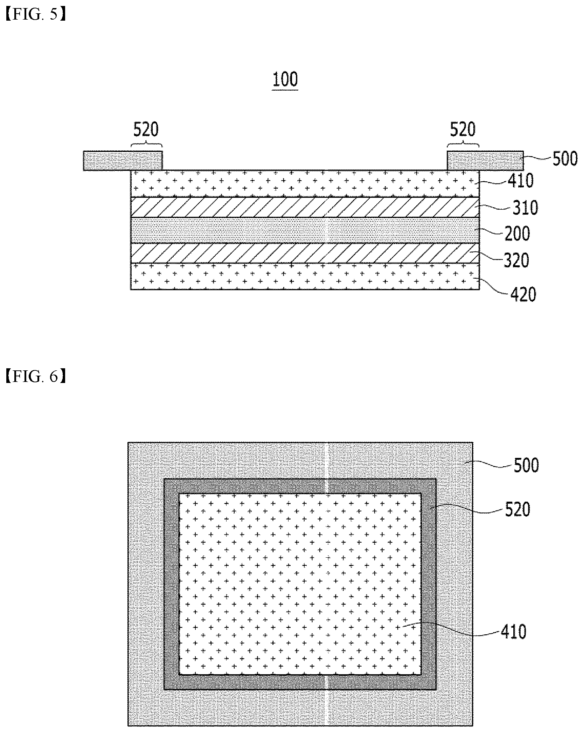

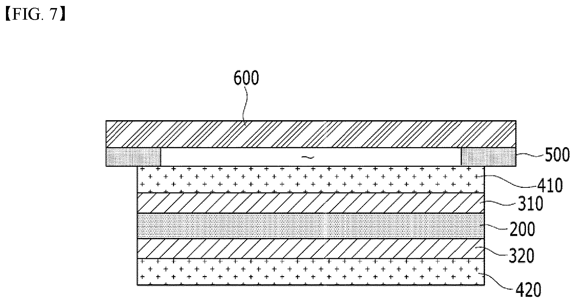

Fig. 4 is a cross-sectional view showing the structure of a printed circuit board according to another embodiment of the present disclosure. Fig. 5 is a cross-sectional view showing the structure of a printed circuit board in which the printed circuit board of Fig. 4 is partially deformed. Fig. 6 is a plan view of the printed circuit board of Fig. 5 as viewed from above. Fig. 7 is a cross-sectional view showing the structure before a metal tab is welded onto the printed circuit board of Fig. 5.

Referring to Figs. 4 to 6, the solder resist layer 500 of the printed circuit board according to the present embodiment may cover a part of the first copper foil layer 410. In particular, the solder resist layer 500 may cover an outer edge part of the first copper foil layer 410. Further, an edge part 520 inside the solder resist layer may be formed as the portion on the solder resist layer 500 at the position where the solder resist layer 500 and the outer edge part of the first copper foil layer 410 overlap.

More specifically, referring to Fig. 4, the solder resist layer 500 may be formed so that there is no portion overlapping the first copper foil layer 410. Also, referring to Fig. 5, a portion where the solder resist layer 500 and the first copper foil layer 410 overlap can be formed so that an edge part 520 inside the solder resist layer is formed. Therefore, the solder resist layer 500 can be stably formed onto the first copper foil layer 410 by the edge part 520 inside the solder resist layer. Further, as shown in Fig. 7, a metal tab 600 may be formed on an upper part of the solder resist layer 500.

As described above, in order for the solder resist layer 500 to cover the outer edge part of the first copper foil layer 410, the outer size of the solder resist layer 500 may be formed to be larger than the outer size of the first copper foil layer 410, and the outer size of the solder resist layer 500 may be formed to be equal to the outer size of the first copper foil layer 410. At this time, the outer size may mean the outer size of the solder resist layer 500 and the first copper foil layer 410 shown in Fig. 6. In addition, the inner size of the solder resist layer 500 may be formed to be smaller than the outer size of the first copper foil layer 410.

By forming to the above size, as shown in Fig. 8, the metal tab 600 can be stably formed on the solder resist layer 500, and when the welding is performed, a gap G can be formed to prevent damage to the inner layer.

Next, a manufacturing method of a printed circuit board according to another embodiment of the present disclosure will be described. All of the contents concerning the printed circuit board described above can be applied to the manufacturing method of the printed circuit board according to the present embodiment, and since there are redundant contents that overlap with those described above, only the portions that differ from the contents described above will be described.

The manufacturing method of the printed circuit board according to the present embodiment includes a step (S100) of forming an inner layer 200, a first insulating layer 310 formed on an upper part of the inner layer 200, and a first copper foil layer 410 formed on an upper part of the first insulating layer 310; and a step (S200) of forming a solder resist layer 500 on an upper part of the first copper foil layer 410, wherein when welding a metal tab 600 onto the solder resist layer 500, a welding portion 700 that couples the metal tab 600 and the first copper foil layer 410 is formed, and a gap G is formed at a portion adjacent to the welding portion 700. In addition, the gap G may be formed on both side surfaces on the basis of the welding portion 700.

In addition, in the manufacturing method of the printed circuit board according to the present embodiment, the step (S100) of forming an inner layer 200, a first insulating layer 310 formed on an upper part of the inner layer 200, and a first copper foil layer 410 formed on an upper part of the first insulating layer 310 may further comprise forming a second insulating layer 320 formed in a lower part of the inner layer 200 and a second copper foil layer 420 formed in a lower part of the second insulating layer 320.

Looking more closely at Fig. 8, although the solder resist layer 500 is not shown in Fig. 8, the gap G formed between the metal tab 600 and the first copper foil layer 410 may match or correspond to the thickness of the solder resist layer 500.

The gap G may separate the metal tab 600 and the first copper foil layer 410, and particularly, the gap G may be formed on both sides on the basis of the welding portion 700 to secure a separation distance between the metal tab 600 and the first copper foil layer 410.

At this time, the thickness of the solder resist layer 500 may be between 50 µm and 200 µm, preferably between 75 µm and 150 µm, and more preferably between 80 µm and 100 µm.

Therefore, the gap G may also be formed in a range of 50 µm to 200 µm, preferably in a range of 75 µm to 150 µm, and more preferably in a range of 80 µm to 100 µm.

When the metal tab 600 is welded onto the printed circuit board 100 in order to form the gap G, a part or all of the solder resist layer 500 may be removed. This is for removing the solder resist layer 500 by the heat generated by welding, and even if a part or all of the solder resist layer 500 is removed, a part of the metal tab 600 is connected to the first copper foil layer 410 by the welding, so that a metal tab 600 can be welded onto the printed circuit board 100. At this time, the gap G increases the distance between the metal tab 600 and the inner layer 200, which prevents a part of the molten metal tab 600 from reaching the inner layer 200 even if the metal tab 600 is welded, thereby capable of preventing damage to the inner layer 200.

Therefore, when the metal tab 600 is welded, a part or all of the solder resist layer 500 can be removed to form a gap G between the metal tab 600 and the first copper foil layer 410. At this time, even if the gap G is formed, the metal tab 600 may be connected to the first copper foil layer 410 via the welding, and particularly, the metal tab 600 and the first copper foil layer 410 may be connected via the welding portion 700.

Meanwhile, the solder resist layer 500 may cover the entire surface of the first copper foil layer 410. Also, the solder resist layer 500 may cover a part of the first copper foil layer 410. In particular, the solder resist layer 500 may cover the outer edge part of the first copper foil layer 410. Further, an edge part 520 inside the solder resist layer may be formed as the portion on the solder resist layer 500 at the position where the solder resist layer 500 and the outer edge part of the first copper foil layer 410 overlap.

By manufacturing the printed circuit board by the method as described above, it is possible to prevent damage to the inner layer of the printed circuit board during welding of the metal tab.

A battery pack according to another embodiment of the present disclosure will be described below.

The battery pack according to the present embodiment includes the above-mentioned printed circuit board. In addition, the battery pack of the present disclosure may have a structure in which one or more of the battery modules according to the present embodiment are gathered, and packed together with a battery management system (BMS) and a cooling device that control and manage battery's temperature, voltage, etc. Therefore, the printed circuit board can be used as a part of the constituent elements of the battery management system (BMS).

Further, the battery pack can be applied to various devices. Such a device can be applied to a vehicle means such as an electric bicycle, an electric vehicle, or a hybrid vehicle, but the present disclosure is not limited thereto, and is applicable to various devices that can use a battery module, which is also falls under the scope of the present disclosure.

Although preferred embodiments of the present disclosure have been described in detail above, the scope of the present disclosure is not limited thereto, and numerous other modifications can be carried out by those skilled in the art, without departing from the invention described in the appended claims. Further, these modifications should not be understood individually from the technical spirit or perspective of the present disclosure.

### [Description of Reference Numerals]

100: printed circuit board
200: inner layer
310: first insulating layer
410: first copper foil layer
500: solder resist layer
600: metal tab
700: welding portion

## Claims

1. A printed circuit board (100) comprising:
an inner layer (200);
a first insulating layer (310) formed on an upper part of the inner layer (200);
a first copper foil layer (410) formed on an upper part of the first insulating layer (310); and
**characterised by**
a solder resist layer (500) formed on an upper part of the first copper foil layer (410), and
in that a metal tab (600) is welded onto the solder resist layer (500), in that a welded portion (700) couples the metal tab (600) and the first copper foil layer (410), and a gap (G) is formed at a portion adjacent to the welded portion (700),
wherein the gap (G) separates the metal tab (600) and the first copper foil layer (410).

2. The printed circuit board (100) according to claim 1, wherein:
the gap (G) is between 50 µm and 200 µm.

3. The printed circuit board (100) according to claim 1, wherein:
the solder resist layer (500) covers a part of the first copper foil layer (410).

4. The printed circuit board (100) according to claim 3, wherein:
the solder resist layer (500) covers an outer edge part (520) of the first copper foil layer (410).

5. The printed circuit board (100) according to claim 4, wherein:
an outer size of the solder resist layer (500) is formed to be larger than an outer size of the first copper foil layer (410).

6. The printed circuit board (100) according to claim 1, wherein:
a size of the solder resist layer (500) is formed to be smaller than or equal to a size of the metal tab (600).

7. The printed circuit board (100) according to claim 1, wherein:
a size of the first copper foil layer (410) is formed to be smaller than a size of the metal tab (600).

8. The printed circuit board (100) according to claim 1, wherein:
the metal tab (600) is connected to the first copper foil layer (410) via the welding.

9. A manufacturing method of a printed circuit board (100), the method comprising the steps of:
forming an inner layer (200), a first insulating layer (310) formed on an upper part of the inner layer (200), and a first copper foil layer (410) formed on an upper part of the first insulating layer (310); and
**characterised by**
forming a solder resist layer (500) on an upper part of the first copper foil layer (410),
and in that when welding a metal tab (600) onto the solder resist layer (500), a welded portion (700) that couples the metal tab (600) and the first copper foil layer (410) is formed, and a gap (G) is formed at a portion adjacent to the welded portion (700) and separates the metal tab (600) and the first copper foil layer (410).

10. The manufacturing method of a printed circuit board (100) according to claim 9, wherein:
when welding the metal tab (600), a part or all of the solder resist layer (500) is removed to form the gap (G).

11. The manufacturing method of a printed circuit board (100) according to claim 9, wherein:
the gap (G) is between 50 µm and 200 µm.

12. The manufacturing method of a printed circuit board (100) according to claim 9, wherein:
the solder resist layer (500) covers a part of the first copper foil layer (410).

13. The manufacturing method of a printed circuit board (100) according to claim 12, wherein:
the solder resist layer (500) covers an outer edge part (520) of the first copper foil layer (410).

14. A battery pack comprising the printed circuit board (100) as set forth in claim 1.

## Patentansprüche

1. Leiterplatte (100), umfassend:
eine innere Lage (200);
eine erste isolierende Lage (310), welche an einem oberen Teil der inneren Lage (200) gebildet ist;
eine erste Kupferfolienlage (410), welche an einem oberen Teil der ersten isolierenden Lage (310) gebildet ist; und
**dadurch gekennzeichnet, dass** eine Lötresistlage (500), welche an einem oberen Teil der ersten Kupferfolienlage (410) gebildet ist, und
dass eine Metalllasche (600) auf die Lötresistlage (500) geschweißt ist, dass ein geschweißter Abschnitt (700) die Metalllasche (600) und die erste Kupferfolienlage (410) koppelt und, dass ein Spalt (G) an einem Abschnitt gebildet ist, welcher benachbart zu dem geschweißten Abschnitt (700) ist,
wobei der Spalt (G) die Metalllasche (600) und die erste Kupferfolienschicht (410) separiert.

2. Leiterplatte (100) nach Anspruch 1, wobei:
der Spalt (G) zwischen 50 µm und 200 µm ist.

3. Leiterplatte (100) nach Anspruch 1, wobei:
die Lötresistlage (500) einen Teil der ersten Kupferfolienlage (410) bedeckt.

4. Leiterplatte (100) nach Anspruch 3, wobei:
die Lötresistlage (500) einen äußeren Randteil (520) der ersten Kupferfolienlage (410) bedeckt.

5. Leiterplatte (100) nach Anspruch 4, wobei:
eine äußere Größe der Lötresistlage (500) gebildet ist, um größer als eine äußere Größe der ersten Kupferfolienlage (410) zu sein.

6. Leiterplatte (100) nach Anspruch 1, wobei:
eine Größe der Lötresistlage (500) gebildet ist, um kleiner als oder gleich wie äußere Größe der Metalllasche (600) zu sein.

7. Leiterplatte (100) nach Anspruch 1, wobei:
eine Größe ersten Kupferfolienlage (410) gebildet ist, um kleiner als eine Größe der Metalllasche (600) zu sein.

8. Leiterplatte (100) nach Anspruch 1, wobei:
die Metalllasche (600) mit der ersten Kupferfolienlage (410) über das Verschweißen verbunden ist.

9. Herstellungsverfahren einer Leiterplatte (100) wobei das Verfahren die Schritte umfasst, aus:
Bilden einer inneren Lage (200), einer ersten isolierenden Lage (310), welche an einem oberen Teil der inneren Lage (200) gebildet ist, und einer ersten Kupferfolienlage (410), welche an einem oberen Teil der ersten isolierenden Lage (310) gebildet ist; und
**gekennzeichnet durch** ein Bilden einer Lötresistlage (500) an einem oberen Teil der ersten Kupferfolienlage (410) und, dass, wenn eine Metalllasche (600) auf die Lötresistlage (500) geschweißt wird, ein geschweißter Abschnitt (700) gebildet wird, welcher die Metalllasche (600) und die erste Kupferfolienlage (410) koppelt, und, dass ein Spalt (G) an einem Abschnitt gebildet wird, welcher benachbart zu dem geschweißten Abschnitt (700) ist, und die Metalllasche (600) und die erste Kupferfolienschicht (410) separiert.

10. Herstellungsverfahren einer Leiterplatte (100) nach Anspruch 9, wobei:
wenn die Metalllasche (600) geschweißt wird, ein Teil oder alles der Lötresistlage (500) entfernt wird, um den Spalt (G) zu bilden.

11. Herstellungsverfahren einer Leiterplatte (100) nach Anspruch 9, wobei:
der Spalt (G) zwischen 50 µm und 200 µm ist.

12. Herstellungsverfahren einer Leiterplatte (100) nach Anspruch 9, wobei:
die Lötresistlage (500) einen Teil der ersten Kupferfolienlage (410) bedeckt.

13. Herstellungsverfahren einer Leiterplatte (100) nach Anspruch 12, wobei:
die Lötresistlage (500) einen äußeren Randteil (520) der ersten Kupferfolienlage (410) bedeckt.

14. Batteriepack, welcher die Leiterplatte (100) nach Anspruch 1 umfasst.

## Revendications

1. Carte de circuit imprimé (100) comprenant :
une couche intérieure (200) ;
une première couche isolante (310) formée sur une partie supérieure de la couche intérieure (200) ;
une première couche de feuille de cuivre (410) formée sur une partie supérieure de la première couche isolante (310) ; et
**caractérisée par**
une couche de réserve de soudure (500) formée sur une partie supérieure de la première couche de feuille de cuivre (410), et
en ce qu'une languette métallique (600) est soudée sur la couche de réserve de soudure (500), en ce qu'une portion soudée (700) couple la languette métallique (600) et la première couche de feuille de cuivre (410), et un espace (G) est formé au niveau d'une portion adjacente à la portion soudée (700),
l'espace (G) séparant la languette métallique (600) et la première couche de feuille de cuivre (410).

2. Carte de circuit imprimé (100) selon la revendication 1, dans laquelle :
l'espace (G) est compris entre 50 µm et 200 µm.

3. Carte de circuit imprimé (100) selon la revendication 1, dans laquelle :
la couche de réserve de soudure (500) recouvre une partie de la première couche de feuille de cuivre (410).

4. Carte de circuit imprimé (100) selon la revendication 3, dans laquelle :
la couche de réserve de soudure (500) recouvre une partie de bord extérieure (520) de la première couche de feuille de cuivre (410).

5. Carte de circuit imprimé (100) selon la revendication 4, dans laquelle :
une taille extérieure de la couche de réserve de soudure (500) est formée pour être plus grande qu'une taille extérieure de la première couche de feuille de cuivre (410).

6. Carte de circuit imprimé (100) selon la revendication 1, dans laquelle :
une taille de la couche de réserve de soudure (500) est formée pour être plus petite ou égale à une taille de la languette métallique (600).

7. Carte de circuit imprimé (100) selon la revendication 1, dans laquelle :
une taille de la première couche de feuille de cuivre (410) est formée pour être plus petite qu'une taille de la languette métallique (600).

8. Carte de circuit imprimé (100) selon la revendication 1, dans laquelle :
la languette métallique (600) est reliée à la première couche de feuille de cuivre (410) via la soudure.

9. Procédé de fabrication d'une carte de circuit imprimé (100), le procédé comprenant les étapes de :
formation d'une couche intérieure (200), d'une première couche isolante (310) formée sur une partie supérieure de la couche intérieure (200), et d'une première couche de feuille de cuivre (410) formée sur une partie supérieure de la première couche isolante (310) ; et
**caractérisé par**
une formation d'une couche de réserve de soudure (500) sur une partie supérieure de la première couche de feuille de cuivre (410), et
en ce que, lors d'un soudage d'une languette métallique (600) sur la couche de réserve de soudure (500), une portion soudée (700) qui couple la languette métallique (600) et la première couche de feuille de cuivre (410) est formée, et un espace (G) est formé au niveau d'une portion adjacente à la portion soudée (700) et sépare la languette métallique (600) et la première couche de feuille de cuivre (410).

10. Procédé de fabrication d'une carte de circuit imprimé (100) selon la revendication 9, dans lequel :
lors du soudage de la languette métallique (600), une partie ou la totalité de la couche de réserve de soudure (500) est retirée pour former l'espace (G).

11. Procédé de fabrication d'une carte de circuit imprimé (100) selon la revendication 9, dans lequel :
l'espace (G) est compris entre 50 µm et 200 µm.

12. Procédé de fabrication d'une carte de circuit imprimé (100) selon la revendication 9, dans lequel :
la couche de réserve de soudure (500) recouvre une partie de la première couche de feuille de cuivre (410).

13. Procédé de fabrication d'une carte de circuit imprimé (100) selon la revendication 12, dans lequel :
la couche de réserve de soudure (500) recouvre une partie de bord extérieure (520) de la première couche de feuille de cuivre (410).

14. Bloc-batterie comprenant la carte de circuit imprimé (100) selon la revendication 1.
